(19) Europäisches Patentamt
European Patent Office
Office européen des brevets

(11) **EP 4 739 060 A1**

(12) **EUROPEAN PATENT APPLICATION**

(43) Date of publication:
06.05.2026 Bulletin 2026/19

(51) International Patent Classification (IPC):
$H10N\ 70/20^{(2023.01)}$     $H10N\ 70/00^{(2023.01)}$

(21) Application number: 24209371.4

(22) Date of filing: 29.10.2024

(52) Cooperative Patent Classification (CPC):
H10N 70/8828; H10N 70/231; H10N 70/823;
H10N 70/8613; H10N 70/8825

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicants:
• Infineon Technologies AG
85579 Neubiberg (DE)
• RWTH Aachen University
52062 Aachen (DE)

(72) Inventors:
• KADOW, Christoph
82131 Gauting (DE)
• STENZ, Christian
56062 Aachen (DE)
• WUTTIG, Matthias
52074 Aachen (DE)

(74) Representative: Kraus & Lederer PartGmbB
Thomas-Wimmer-Ring 15
80539 München (DE)

(54) **RADIO FREQUENCY SWITCH AND RADIO FREQUENCY DEVICE**

(57)    A radio frequency switch (100) is provided. The switch includes a first radio frequency terminal (106), a second radio frequency terminal (108), and a phase change material (114) electrically coupled between the first radio frequency terminal (106) and the second radio frequency terminal (108).

The phase change material comprises an alloy of at least three different chemical elements, wherein the alloy contains at least one of In, Ag and Sn.

Fig. 3

EP 4 739 060 A1

**Description**

TECHNICAL FIELD

The present application relates to radio frequency switches and radio frequency devices.

BACKGROUND

The technical requirements for radio frequency (RF) applications using high frequencies, such as radar sensing and mobile communication according to the 5G standard and future 6G, are increasing. In particular, switches having improved characteristics compared to state-of-the-art CMOS switches will be required to meet future demands. Phase change switches are considered as promising candidates for switching RF signals. Such phase change switches use a phase change material (PCM) which typically exhibits a higher electric conductivity in a crystalline phase state than in an amorphous phase state. By changing the phase state of the phase change material, a switch device including such a material may be switched on and off.

For example, to change the phase state from amorphous to crystalline, typically a heater is employed heating the phase change material causing crystallization. This switching on by causing crystallization is also referred to as a set operation. In the set operation, the heater is actuated in such a way that the temperature of the phase change material is above its crystallization temperature, typically about 250°C, but below the melting point typically in a range of 600°C to 900°C, for example. The length of the heating pulse caused by the heater is chosen such that any amorphous region present in the PCM can regrow into the crystalline phase state.

When switching off the switching device, also referred to as reset operation, the heater is actuated in such a way that the temperature of the PCM is raised above the melting point (for example above about 600°C to 900°C) followed by a comparatively rapid cool-down which freezes the phase change material into an amorphous state.

Suitable phase change materials conventionally used for such phase change switches include germanium telluride (GeTe), antimony telluride ($Sb_2Te_3$) or germanium-antimony-tellurium (GeSbTe, usually referred to as GST), and heaters may be made of a material like polycrystalline silicon or tungsten.

While these materials allow the manufacturing of switches for RF applications, requirements for such switches regarding their properties are increasing.

There is a need for RF switches with very low insertion loss. This need is driven by several applications: The first are RF-tuners for mobile phone antennas which require low insertion loss on smaller and smaller chip areas at established 5G frequencies up to 6GHz. The second are RF systems operating at higher frequencies, e.g. X-band and above, which also need low insertion loss switches.

The present invention addresses the technical problem of providing improved RF-switches and RF-tuners. This is achieved by finding more suitable phase-change materials (PCMs) than are used in the state-of-the-art. So far, the only phase-change materials, used successfully for PCM-based RF-switches, are GeTe and $Sb_2Te_3$. Another option are PCMs from the Ge-Sb-Te ternary phase diagram. While ternary Ge-Sb-Te compounds are widely used for memory applications, they are not a good choice for RF-applications for the following reasons: First, their electrical resistivity in the on-state (= crystalline) state is fairly high compared to GeTe and $Sb_2Te_3$. Second, their switching behavior is very complex due to multiple crystalline phases which makes it hard to switch into a low-resistance on-state.

Usually, advanced functional materials like PCMs are discussed in terms of their band structure and the resulting properties. Recently, a rather different approach and its potential for designing advanced functional materials has been described. This approach is based on the assumption that a quantification of chemical bonding provides the metric to describe systematic trends in the resulting material properties. The close interrelation between precise quantum chemical bonding descriptors and materials properties hence enables the application of these descriptors as property predictors.

SUMMARY

According to an embodiment, a radio frequency switch is provided, comprising:

a first radio frequency terminal,
a second radio frequency terminal, and
a phase change material electrically coupled between the first radio frequency terminal and the second radio frequency terminal,

wherein the phase change material comprises an alloy of at least three different chemical elements, characterized in that the alloy contains at least one of In, Ag and Sn.

According to another embodiment, a radio frequency device is provided, comprising:

the radio frequency switch explained above, and
a radio frequency circuit coupled to at least one of the first radio frequency terminal and the second radio frequency terminal.

The above summary is merely a brief overview over some embodiments and is not to be construed as limiting.

BRIEF DESCRIPTION OF THE DRAWINGS

Fig. 1 is a schematic side view of a radio frequency switch according to an embodiment,

Fig. 2 is a block diagram of a radio frequency device according to an embodiment,

Fig. 3 is a material map illustrating the selection of phase change materials for the radio frequency switch of Fig. 1, and

Fig. 4 is a diagram illustrating properties of phase change materials used in some embodiments.

DETAILED DESCRIPTION

In the following, various embodiments will be described in detail referring to the attached drawings. The embodiments described hereinafter are to be taken as examples only and are not to be construed as limiting. For example, while in embodiments specific arrangements or components are provided, in other embodiments other configurations may be used.

Besides features (or for example components, elements, acts, events or the like) explicitly shown and described, in other embodiments additional features may be provided, for example features used in conventional switch devices using phase change materials. For example, embodiments described herein relate to selecting phase change materials for phase change switches to be used as radio frequency switches, and other components and features, like spatial arrangement of heaters and phase change material, radio frequency (RF) circuitry using the switch device and the like may be implemented in a conventional manner. Such RF circuitry may be integrated with the described switch devices on the same substrate, but may also be provided separately for example, on one or more separate chip dies, which in some implementations then may be combined with a switch device in a common package. Also, manufacturing implementations like providing phase change material on a substrate like a silicon substrate to implement a phase change switch, providing phase change material in a trench in a silicon substrate for manufacturing the switch device and the like may be performed in any conventional manner.

A switch based on a phase change material (PCM) will be referred to as a phase change switch or short PCM switch herein. As explained in the introductory portion, such phase change switches may be set to a crystalline phase state or an amorphous phase change, thus changing the resistance of the phase change material and therefore of the switch by several orders of magnitude. In this way, for example an on resistance of a switch in a range of 0,1 to 100 Ω may be achieved, whereas an off-resistance may be several orders of magnitude higher, for example at least in the Kiloohm range.

Implementation details described with respect to one of the embodiments are also applicable to other embodiments.

Embodiments discussed herein relate to radio frequency (RF) switches implemented as PCM switches. The term RF switch relates to switches designed for switching RF signals, i.e. signals having frequencies above 1MHz (Megahertz), in many applications in the GHz (Gigahertz) range.

RF switches

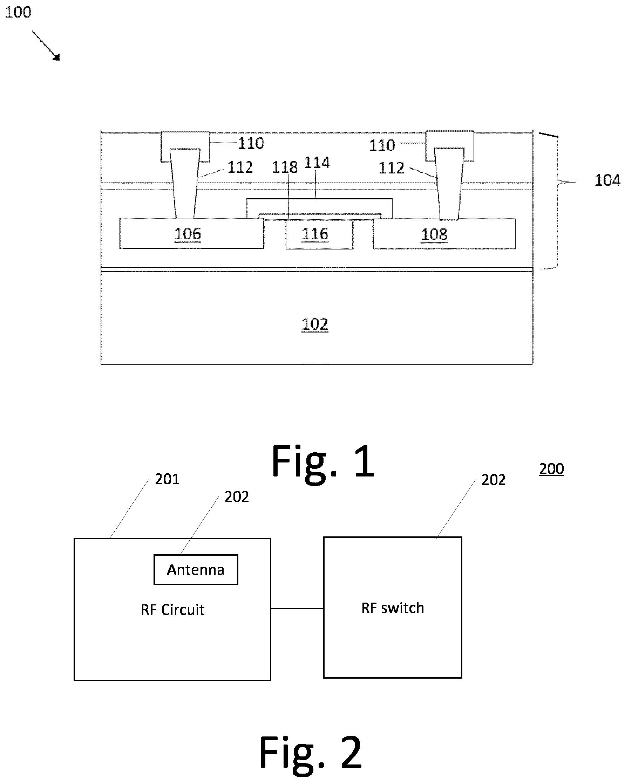

Referring to Figure 1, a RF switch 100 implemented as a PCM switch is depicted, according to an embodiment. The RF switch 100 includes a substrate 102. Generally speaking, the substrate 102 may include any material that is compatible with semiconductor processing techniques, e.g., deposition, etching, etc. For example, the substrate 102 may include semiconductor materials such as silicon (Si), carbon, silicon carbide (SiC), silicon germanium (SiGe), etc. In another example, the substrate 102 includes non-semiconductor material, e.g., sapphire, glass, diamond, etc. In one particular embodiment, the substrate 102 is a commercially available bulk semiconductor wafer, e.g., a silicon wafer. In another example, the substrate 102 is a so-called SOI (Silicon on Insulator) substrate 102, which includes a buried layer of insulating material. The substrate 102 includes a main surface, which may be a substantially planar surface.

The RF switch 100 includes a region of electrically insulating material 104 that is formed on the main surface of the substrate 102. Generally speaking, the region of electrically insulating material 104 can comprise any electrically insulating material that can be formed through typical semiconductor processing techniques such as CVD (chemical vapor deposition). Examples of these electrically insulating materials include semiconductor oxides and nitrides, e.g., silicon nitride (SiN), silicon dioxide ($SiO_2$), silicon oxynitride ($SiOxN_Y$), etc. In another embodiment, the region of electrically insulating material 104 comprises aluminum nitride (AlN). The region of electrically insulating material 104 may be thermally insulating or thermally conductive. The region of electrically insulating material 104 may include multiple layers of the same or different material.

The RF switch 100 further includes first and second RF terminals 106, 108. The first and second RF terminals 106, 108 may be formed from an electrically conductive metal, e.g., copper, aluminum, tungsten, alloys thereof, etc. As shown, the RF switch 100 may further comprise an upper level metallization 110 that is electrically connected to the first and second RF terminals 106, 108 by vertical through-via structures 112. The upper level metallization 110 can be a structured metallization e.g., copper, aluminum, alloys thereof, etc., and the vertical through-via structures 112 comprise a conductive metal such as tungsten, copper, nickel, aluminum, etc. The upper level metallization 110 may be connected to or form externally accessible terminals of the RF switch 100. In operation, RF signals are applied to first and/or second RF terminal 106, 108.

The RF switch 100 further includes a strip of phase change material 114. The strip of phase change material 114 may have an elongated geometry that extends lengthwise parallel to the main surface of the substrate 102. The strip of phase change material 114 is formed from a material that can be transitioned between two different phases that each have different electrical conductivity. For example, strip of phase change material 114 may comprise a material that changes from an amorphous state to a crystalline state based upon the application of heat to the phase change material, wherein the phase change material is electrically insulating (i.e., blocks a conductive connection) in the amorphous state and is electrically conductive (i.e., provides a low-resistance current path) in the crystalline state. As strip of phase change material 114, one or more materials as discussed further below in more detail are used.

The strip of phase change material 114 is connected between the first and second RF terminals 106, 108. That is, the strip of phase change material 114 is in low-ohmic contact with both the first and second RF terminals 106, 108, either through direct physical contact or by one or more conductive intermediaries that provide a low-resistance electrical connection. In one example, a conductive material such as TiN, W, TiPtAu is provided between the first and second RF terminals 106, 108 and the phase change material to improve the electrical connection between the two. When the strip of phase change material 114 is in a conductive state, current flows between the first and second RF terminals 106, 108 in a current flow direction of the strip of phase change material 114.

The RF switch 100 further includes at least one heating element 116. The heating element 116 is arranged adjacent to the strip of phase change material 114. In the depicted embodiment, the strip of phase change material 114 is disposed above each of the first and second RF terminals 106, 108 and the heating element 116. The heating element 116 is arranged and configured to apply heat to the strip of phase change material 114. For example, the heating element 116 may comprise a conductive or semi-conductive material that converts electrical energy into heat through ohmic heating. The heating element 116 may be connected between electrically conductive heating terminals, which are not shown in the cross-sectional view of Fig. 1. For example, the heating element 116 may extend transversely to the current flow direction of the phase change material 114 and contact heating terminals that are in locations that are spaced apart from the cross-sectional plane of Fig. 1. The heating terminals are electrically conductive structures that can be biased to force a current through the heating element. The heating element 116 is separated from the strip of phase change material 114 by an insulating liner 118. The insulating liner 118 electrically isolates the heating element 116 from the strip of phase change material 114 while simultaneously permitting substantial heat transfer between the two. To this end, the insulating liner 118 may be a relatively thin (e.g., less than 1 μm thick and more typically less than 100 nm thick) layer of dielectric material, e.g., silicon dioxide ($SiO_2$), silicon nitride (SiN), aluminum nitride (AlN) etc.

The working principle of the RF switch 100 is as follows. The heating element 116 is configured to control a conductive connection between the first and second RF terminals 106, 108 by applying heat to the strip of phase change material 114. In an OFF state of the RF switch 100, the phase change material of the strip of phase change material 114 is in an amorphous state or partially amorphous. As a result, the strip of phase change material 114 blocks a voltage applied to the first and second RF terminals 106, 108. In an ON state of the RF switch 100, the phase change material of the strip of phase change material 114 is in a crystalline state. As a result, the strip of phase change material 114 provides a low-resistance electrical connection between the first and second RF terminals 106, 108. The RF switch 100 performs a switching operation by using the heating element 116 to heat the strip of phase change material 114. The phase change material may be transitioned to the amorphous state by applying short pulses (e.g., pulses in the range of 50 - 1,000 nanoseconds) of high intensity heat which causes the phase change material to reach a melting temperature, e.g., in the range of 600° C to 750° C, followed by a rapid cooling of the material. This is referred to as a "reset pulse." The phase change material may be transitioned to the crystalline state by applying longer duration pulses (e.g., pulses in the range of 0.5 - 10 microseconds) of lower intensity heat, which causes the phase change material to reach a temperature at which the material quickly crystallizes and is highly conductive, e.g., in the range of 250° C to 350° C. This is referred to as a "set pulse."

While a specific geometry of the RF switch is shown in Fig. 1, other geometries are also possible. For example, while heating element 116 is shown below the strip of phase change material 114, in other embodiments heating element 116 may be arranged above the strip of phase change material 114. In yet other embodiments, heating element 116 may be omitted, and heating may be performed by a heating current through the strip of phase change material 114 via terminal 106, 108. Also the geometry of the electrical contacting shown (e.g. terminal 106, 108, vias 112 etc.) may vary as long as RF signals may be applied to the strip of phase change material 114 and a heating current may be applied to heating element 116.

Fig. 2 illustrates a radio frequency (RF) device 200 according to an embodiment. RF device 200 comprises an RF circuit 201, i.e. a circuit processing RF signals, and an RF switch 202. RF switch 202 may be implemented as discussed for RF switch 100 of Fig. 1. One or more RF terminals of RF switch 202 (e.g. terminals 106, 108) are coupled to RF circuit 201 to switch RF signals.

In some embodiments, RF circuit 201 may be an RF communication circuit including an antenna 202. In such an embodiment, RF switch 202 may for example be used for antenna tuning, by selectively coupling antenna 202 to tuning elements like tuning capacitors or tuning inductors.

Selection of suitable phase change materials

Next, phase change materials used in embodiments e.g. as the strip of phase change material 114 of Fig. 1 will be discussed.

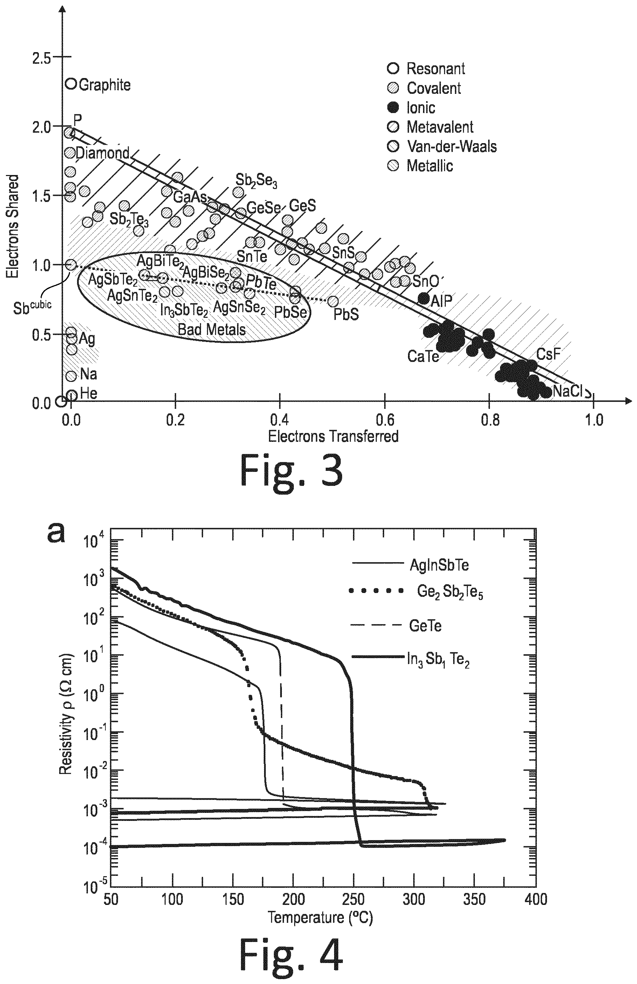

According to the present invention, the properties of phase-change materials are tailored to the needs of RF switches and RF tuners. These properties include in particular a lower resistivity in the on-state and higher Roff/Ron-ratio than GeTe - the present state-of-the-art - provides. These materials comprise at least three different chemical elements, specific examples are outlined below. Preferably, suitable materials have a small Peierls distortion and small charge transfer between adjacent atoms. Suitable materials can be identified in the material map, as shown in Fig. 3.

One of the key characteristics of an RF-switch is the on-state resistance, Ron. This number should be as small as possible. Preferably, the PCM of the invention in an on-state of the radio frequency switch has a resistivity below 3.4E-4 Ohm-cm. A reduction in the Ron directly leads to a reduced insertion loss. The most important material parameter contributing to Ron is the electrical resistivity in the on-state or crystalline state of the phase-change material. For state-of-the-art GeTe films, thicknesses between 100nm and 300nm are used and resistivities down to 3.4E-4 Ohm-cm have been reported [Moon et al., "10.6 THz Figure-of-Merit Phase-change RF Switches with Embedded Micro-heater", IEEE SiRF 2015]. Furthermore, the off-state resistance, Roff, and the ratio Roff/Ron should be as high as possible. To improve over the state-of-the-art of GeTe-based device, Roff/Ron needs to be equal or preferably larger than 3E4. Preferably, the PCM of the invention results in a resistance ratio between an off state of the radio frequency switch and an on state of the radio frequency switch of at least 3E4.

In general, the electrical resistivity is given by the carrier concentration and the carrier mobility. This invention describes ways to improve both for phase change materials: To have high carrier mobility in phase change materials, one needs to identify materials in the material map with a small Peierls distortion, which can be determined by crystallographic measurements, as well as the position in the material map, as shown in Figure 3. Version of the map have been published in Guarneri et al., "Metavalent Bonding in Crystalline Solids: How Does It Collapse?" Adv. Mater. 2021, 33, 2102356; and in Wuttig et al., "Revisiting the Nature of Chemical Bonding in Chalcogenides to Explain and Design their Properties", Adv. Mater. 2023, 35, 2208485.

Referring to Figure 3, the map is spanned by the number of electrons shared (ES) between adjacent atoms and their electron transfer. Different patterns characterize different material properties and have been related to different types of bonds. The materials indicated in Figure 3 correspond to the following types of bonds:

Graphite: Resonant
P, Diamond, GaAs, $Sb_2Se_3$, GeSe, GeS, SnS, SnO: Covalent $Sb_2Te_3$, $Sb^{cubic}$, $AgSbTe_2$, $AgBiTe_2$, $AgBiSe_2$, SnTe, PbTe, PbSe, PbS: Metavalent
Ag, Na, $AgSnTe_2$ (Bad Metal), $In_3SbTe_2$ (Bad Metal), $AgSnSe_2$ (Bad Metal): Metallic
He: Van-der-Waals
AlP, CaTe, CsF, NaCl: Ionic

The broad line at the top (between 2.0 electrons shared and 1.0 electrons transferred) describes the transition from ideal covalent bonds (large ES, small ET) to perfect ionic bonds (large ET, small ES). The dashed line (going through the ellipse) indicates metavalently bonded solids with perfect octahedral order. Materials in the vicinity of the ellipse appear particularly promising since they should combine large charge carrier mobilities with high charge carrier densities in their crystalline state.

Materials with the desired structure and bonding are located in the metavalent region of the map, or the region slightly below the dashed line in the map. This region of the map contains compounds which are predominantly p-bonded, i.e. employ p-electrons to form bonds between adjacent atoms, such as GeTe. These compounds often have an octahedral-like atomic arrangement. The corresponding charge carrier mobility in this region of the map decreases often with increasing Peierls distortion, which is accompanied by an increase in ES. Materials with small Peierls distortion are located in the metavalent region close to the dashed line.

To obtain high carrier concentrations one has to look for materials in the metavalent region of the map or slightly below the dashed line, which have their Fermi energy located in the valence band. This happens if the number of p-electrons in the valence band is less than three per atom. This scenario is encountered for three preferred examples of target materials, $In_3SbTe_2$, $AgSnSe_2$ and $AgSnTe_2$. Their location is indicated in the map in Fig. 3.

Thus, phase change material (PCM) suitable for use in a radio frequency switch may be determined by a method comprising the following steps:

(S1) Setting which chemical elements may be contained in the PCM,
(S2) Calculating the data for the material map as described for instance in References 1 and 2,
(S3) Mapping the number of electrons shared between adjacent atoms and the number of electrons transferred between adjacent atoms, and
(S4) Identifying suitable materials from the map obtained in step (S3).

In step (S1), it is set which chemical elements can be contained in the PCM. The determination of suitable elements can be made for instance based on the elements contained in known materials, such as GeTe, $Sb_2Te_3$, or ternary Ge-Sb-Te alloys.

In step (S2) Ref. 1 and 2 are the following publications: Guarneri et al., "Metavalent Bonding in Crystalline Solids: How Does It Collapse?" Adv. Mater. 2021, 33, 2102356; and Wuttig et al., "Revisiting the Nature of Chemical Bonding in Chalcogenides to Explain and Design their Properties", Adv. Mater. 2023, 35, 2208485. It is understood that these calculations only have to be conducted for the crystalline phase. If the location of the crystalline material in the map is in the target area (metavalent and ellipse), a large change of bonding (and properties) upon amorphization can be expected.

An exemplary map according to step (S3) is shown in Fig. 3.

In step (S4), the following parameters of the crystalline phase indicate that a material is a promising PCM candidate for RF switch applications:

- small Peierls distortion

- large charge carrier mobility

- high charge carrier density

- Fermi energy located in the valence band

- metavalently bonded solid

- small charge transfer between adjacent atoms

A small Peierls distortion can be determined by the position in the material map. In addition, crystallographic measurements can be performed to confirm or refine the result.

As outlined above, for instance, the three target compounds $In_3SbTe_2$, $AgSnSe_2$ and $AgSnTe_2$ have been identified with the aforementioned method.

Optionally, in a further step, promising candidates for PCM can be synthesized in the amorphous state according to known methods and their resistivity upon annealing and subsequent crystallization can be measured experimentally, as described below. The obtained results can be used for a decision if the candidate material is suitable for use in a radio frequency switch.

Evaluation of properties of phase change materials

Referring to Figure 4, resistivity data for $In_3SbTe_2$ in comparison to GeTe and some other compounds are shown. Fig. 4 illustrates the resistivity of different phase change films upon annealing and subsequent crystallization.

The measurements were performed as follows: A thin film of phase change material is deposited in its amorphous (= high resistance) state. The resistivity of this thin film of phase change material is then measured continuously during a slow thermal cycle. The resistivity measurement starts in the upper left corner of the graph. The resistivity is high because the sample is in its amorphous state. During the initial temperature rise the resistivity decreases due to the negative temperature coefficient in the amorphous state. At the crystallization temperature, the material crystallizes, and the film's resistivity drops significantly by multiple orders of magnitude during a small temperature interval. From there onwards the material remains in its crystalline state. The temperature is increased further up to the anneal temperature and then ramped down to the ambient temperature. The resistivity measurement stops at the lower left corner. This type of measurement is very useful in material development and characterization. First, it is a straightforward measurement and can be performed quickly. Therefore, it can be used to screen different types of phase-change materials for their suitability in the RF switch application. Second, the thermal cycle is a good indication how the material will evolve during the manufacturing steps after this film deposition. This type of measurement can be used to emulate the thermal budget which the phase change material will experience during the fabrication of a semiconductor device.

As shown in Fig. 4, initially, all films are in the high resistance amorphous state ("off" state). Upon heating, the films crystallize accompanied by a drastic reduction in resistivity ("on" state). The film of 100 nm AgInSbTe (thin solid line) has the lowest crystallization temperature, the highest "on" state resistivity and the smallest resistivity ratio. 100 nm of $Ge_2Sb_2Te_5$ have a higher crystallization temperature and a higher resistivity ratio. 80 nm GeTe thin films (dashed line) possess an even higher crystallization temperature, a higher resistivity ratio and a lower "on" state resistance. This explains, why presently most studies focus on employing GeTe based RF switches. Yet, $In_3SbTe_2$ shows a significantly better performance, i.e. lowest Ron, highest resistivity ratio, and highest crystallization temperature. Hence, $In_3SbTe_2$ would show a significant improvement in RF switches compared to the state-of-the-art.

It can be seen that $In_3SbTe_2$ has a resistivity in the on-state which is approx. a factor of four lower than GeTe and a resistivity in the as-deposited amorphous state which is a factor of two higher than GeTe. Therefore, one expects a significant improvement in the parameters insertion loss, onresistance, and Roff/Ron ratio by using $In_3SbTe_2$ instead of GeTe in a PCM-based RF-switch.

The requirements on material properties differ between applications. This is the reason why in the state-of-the-art different materials are used: For RF-switches the standard choice is GeTe, while for electrical memory cells a standard choice is $Ge_2Sb_2Te_5$.

Preferably, the inventive PCMs have a low-ohmic crystalline state. Preferably, the PCM in an on-state of the radio frequency switch has a resistivity below 3.4E-4 Ohm-cm, more preferably below 2E-5 Ohm-cm. Thus, the value is better than for state-of-the-art GeTe (rho_crystal < 3.4E-4 ohm-cm). For a required Ron, lower resistivity leads to lower device width, which in consequence means less device area, smaller off-capacitances and less power consumptions during switching.

Preferably, the inventive PCMs have a high-ohmic amorphous state. Preferably, the PCM-based Rf switch device has a resistance ratio between an off state of the radio frequency switch and an on state of the radio frequency switch of at least 3E4, more preferably 1E5. Preferably, the resistivity ratio between the amorphous and crystalline phases rho_amorphous/rho_ crystal is larger than 1E5, more preferably larger than 3E5.

Preferably, the inventive PCMs have a crystallization and anneal temperature in a suitable range. Preferably, the crystallization temperature is larger than the maximum ambient temperature during operation. With a suitable margin the crystallization temperature preferably is above 150°C. More preferably, the PCM has a crystallization temperature above 175°C. Preferably, the anneal temperature is below 400°C, i.e. compatible with standard Si CMOS processing. More preferably the PCM has an annealing temperature below 350°C.

Preferably, the first alloy (A1) is a "bad metal" and the second alloy (A2) is a "metavalent material" (MVB). The present inventors have found that doping/alloying the first alloy (A1), which is a "bad metal" according to the material map in Fig. 3, with a second alloy (A2), which is a "metavalent material" according to the material map in Fig. 3, is potentially interesting for RF applications.

The term "metavalent" is described in Wuttig et al., "Revisiting the Nature of Chemical Bonding in Chalcogenides to Explain and Design their Properties", Adv. Mater. 2023, 35, 2208485. It refers to a bonding mechanism, fundamentally different from ionic, metallic, and covalent bonding, based on quantum chemical bonding descriptors. It is characterized by a bonding situation where about one electron (half an electron pair) holds together two adjacent atoms. Hence, metavalent solids occupy a special region in a map spanned by electrons shared (ES) and electrons transferred (ET).

The term "bad metal" is used in condensed matter physics to describe a type of metal that does not exhibit conventional metallic behaviour, especially in terms of electrical conductivity. Due to the absence of a band gap the bad metal shows a finite conductivity towards 0K (positive temperature coefficient of resistivity) like any normal metal, but the conductivity is rather low and (from a simple-metal-theory point of view) shows unexpected behaviour at elevated temperatures.

A prerequisite for successful alloying is a similar crystal structure. For instance, the alloy (A1) and the alloy (A2) both have an octahedral-like atomic arrangement, preferably rock salt like structure, and the lattice mismatch is not larger than 5%. In other words, the following condition is fulfilled:

$$|C1-C2|/C1 \leq 5\%$$

C1: lattice constant of alloy (A1) in Å
C2: lattice constant of alloy (A2) in Å.

Even more preferably, the lattice mismatch is not larger than 3%.

Exemplarily combinations of the bad metals $In_3SbTe_2$ (lattice constant: 6.123 Å), $AgSnTe_2$ (lattice constant: 6.070 Å) and $AgSnSe_2$ (lattice constant: 5.678 Å) with different metavalent materials, together with the lattice mismatch for each combination are shown in the following table.

| metavalent material (MVB) | | | Bad metal, lattice const. [Å] | | |
|---|---|---|---|---|---|
| formula | ICSD Collection Code | lattice constant [Å] | $In_3SbTe_2$ 6.123 | $AgSnTe_2$ 6.070 | $AgSnSe_2$ 5.678 |
| $AgSbSe_2$ | 183032 | 5.757 | - | - | ++ |
| $AgSbTe_2$ | 246487 | 6.078 | ++ | ++ | - |
| $AgBiSe_2$ | 604858 | 5.833 | + | + | ++ |
| $AgBiTe_2$ | 604867 | 6.155 | ++ | ++ | - |
| PbS | 5586 | 5.917 | + | ++ | + |
| PbS:PbSe (1:1) | 77879 | 6.033 | ++ | ++ | - |
| PbSe | 38294 | 6.128 | ++ | ++ | - |
| PbSe:PbTe (1:1) | 77875 | 6.300 | ++ | + | - |
| PbTe | 96506 | 6.460 | - | - | - |
| SnTe | 188547 | 6.318 | + | + | - |
| $GeTe:Sb_2Te_3$ (1:1) | 151756 | 6.043 | ++ | ++ | - |
| $GeTe:Sb_2Te_3$ (2:1) | 159908 | 6.012 | ++ | ++ | - |
| GeTe | 601079 | 5.985 | ++ | ++ | - |
| ++: lattice mismatch not larger than 3% +: lattice mismatch not larger than 5% -: lattice mismatch larger than 5% | | | | | |

In the above table, combinations of bad metals and metavalent materials with a lattice mismatch not larger than 5%, preferably not larger than 3%, are particularly promising materials for RF-Switches.

The radio frequency switch of the present invention can preferably be used in a radio frequency device, such as RF-tuners for mobile phone antennas or RF systems operating at higher frequencies, e.g. X-band and above.

Some embodiments are defined by the following examples:

Item 1. A radio frequency switch, comprising:

a first radio frequency terminal,
a second radio frequency terminal, and
a phase change material electrically coupled between the first radio frequency terminal and the second radio frequency terminal,
wherein the phase change material (PCM) comprises an alloy (A1) of at least three different chemical elements, characterized in that the alloy contains at least one of In, Ag and Sn.

Item 2. The radio frequency switch according to item 1 above, wherein the alloy (A1) comprises Ag and Sn.

Item 3. The radio frequency switch according to item 1 or 2 above, wherein the alloy (A1) has the following chemical formula (I):

$$(X^1_{(n-m)}X^2_m)Y_pZ_r \qquad (I),$$

wherein:

- $X^1$ and $X^2$ are each independently selected from Ag, In and a combination of Ag and In, preferably, selected from Ag and In;
- Y is selected from Sb, Sn, Bi and a combination thereof, preferably, selected from Sb and Sn;
- Z is selected from Te, Se and a combination of Te and Se, preferably, selected from Te and Se;
- n is an integer between 1 and 3,
- m is any number between 0 and 3, provided that (n-m) is > 0, and
- p and r are each independently an integer between 1 and 3, preferably, p is 1, preferably, r is 2.

Item 4. The radio frequency switch according to any of the preceding items, wherein the alloy (A1) is selected from the group consisting of $In_3SbTe_2$, $AgSnSe_2$ and $AgSnTe_2$.

Item 5. The radio frequency switch according to any of the preceding items, wherein the PCM further comprises a second alloy (A2) of at least two different chemical elements, wherein the second alloy contains at least one of Ge, Sn, Pb, Sb, Bi, S, Se, Te and Ag.

Item 6. The radio frequency switch according to item 5 above, wherein the second alloy (A2) is:

- an alloy of at least three different chemical elements selected from the group consisting of Sb, Bi, Se, Te and Ag, or
- an alloy of at least two different chemical elements selected from the group consisting of Ge, Sn, Pb, Sb, S, Se and Te.

Item 7. The radio frequency switch according to item 5 or 6 above, wherein the alloy (A2) has one of the following chemical formulae (II), (III) and (IV):

$$X^3X^4(X^5)_2 \qquad (II)$$

$$X^6X^7 \qquad (III)$$

$$X^6X^7{:}X^8_sX^9_t \qquad (IV)$$

wherein:

- $X^3$ and $X^4$ are each independently selected from Ag, Sb, Bi and a combination thereof, preferably, selected from Ag, Sb and Bi, more preferably, $X^3$ is Ag and $X^4$ is Sb or Bi;
- $X^5$ is selected from Se, Te and a combination of Se and Te, preferably, selected from Se and Te;
- $X^6$ is selected from Ge, Sn, Pb and combinations thereof, preferably, selected from Ge, Sn and Pb;
- $X^7$ is selected from S, Se, Te and combinations thereof, preferably, selected from S, Se and Te;
- $X^8$ is selected from Pb, Sb and a combination of Pb and Sb, preferably, selected from Pb and Sb
- $X^9$ is selected from Se, Te and a combination of Se and Te, preferably, selected from Se and Te; and
- s and t are each independently an integer between 1 and 3.

Item 8. The radio frequency switch according to any of items 5 to 7 above, wherein the alloy (A2) is selected from the group consisting of $AgSbSe_2$, $AgSbTe_2$, $AgBiSe_2$, $AgBiTe_2$, PbS, PbSe, PbTe, SnTe, GeTe, PbS:PbSe (1:1), PbSe:PbTe (1:1), $GeTe{:}Sb_2Te_3$ (1:1) and $GeTe{:}Sb_2Te_3$ (2:1).

Item 9. The radio frequency switch according to any of items 5 to 8 above, wherein the PCM comprises the alloy (A1) in an amount of 50 - 95 at.% and the alloy (A2) in an amount of 5 - 50 at.%, based on the total amount of (A1) and (A2), preferably A1 in an amount of 60 - 95 at.% and A2 in an amount of 5 - 40 at.%, more preferably A1 in an amount of 70 - 95 at.% and A2 in an amount of 5 - 30 at.%.

Item 10. The radio frequency switch according to any of the preceding items, wherein the alloy (A1) has an octahedral-like atomic arrangement, preferably a rock salt like structure.

Item 11. The radio frequency switch according to any of items 5 to 10 above, wherein the alloy (A1) and the alloy (A2) both have an octahedral-like atomic arrangement, preferably a rock salt like structure, and the following condition is fulfilled:

$$|C1-C2|/C1 \leq 5\%,$$

preferably $\leq 3\%$

C1: lattice constant of alloy (A1) in Å
C2: lattice constant of alloy (A2) in Å.

Item 12. The radio frequency switch according to any of the preceding items, wherein the PCM has a crystallization temperature above 150°C.

Item 13. The radio frequency switch according to any of the preceding items, wherein the PCM has an annealing temperature below 400°C.

Item 14. The radio frequency switch according to any of the preceding items, wherein the PCM in an on-state of the radio frequency switch has a resistivity below 3.4E-4 Ohm-cm.

Item 15. The radio frequency switch according to any of the preceding items, wherein the PCM has a resistance ratio between an off state of the radio frequency switch and an on state of the radio frequency switch of at least 3E4.

Item 16. The radio frequency switch according to any of the preceding items, wherein the PCM has a resistivity ratio between the amorphous and crystalline phase above 1E5.

Item 17. The radio frequency switch according to any of items 5 to 16 above, wherein the first alloy (A1) is a "bad metal" and the second alloy (A2) is a "metavalent material".

Item 18. The radio frequency switch of any one of items 1 to 17 above, further comprising a heater thermally coupled to and electrically insulated from the phase change material.

Item 19. A radio frequency device comprising:

the radio frequency switch of any one of items 1 to 18 above, and
a radio frequency circuit coupled to at least one of the first radio frequency terminal and the second radio frequency terminal.

Item 20. The radio frequency device of item 19 above, wherein the radio frequency circuit comprises an antenna.

Item 21. The radio frequency device of item 19 or 20 above, wherein the radio frequency device is configured such that the radio frequency switch switches a signal having a frequency of at least 1 GHz when the radio frequency device is in operation.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

**Claims**

1. A radio frequency switch, comprising:

a first radio frequency terminal,
a second radio frequency terminal, and
a phase change material electrically coupled between the first radio frequency terminal and the second radio frequency terminal,
wherein the phase change material (PCM) comprises an alloy (A1) of at least three different chemical elements, **characterized in that** the alloy contains at least one of In, Ag and Sn.

2. The radio frequency switch according to claim 1, wherein the alloy (A1) has the following chemical formula (I):

$$(X^1_{(n-m)}X^2_m)Y_pZ_r \qquad (I),$$

wherein:

- $X^1$ and $X^2$ are each independently selected from Ag, In and a combination of Ag and In,
- Y is selected from Sb, Sn, Bi and a combination thereof,
- Z is selected from Te, Se and a combination of Te and Se,
- n is an integer between 1 and 3,
- m is any number between 0 and 3, provided that (n-m) is > 0, and
- p and r are each independently an integer between 1 and 3.

3. The radio frequency switch according to claim 1 or 2, wherein the alloy (A1) is selected from the group consisting of $In_3SbTe_2$, $AgSnSe_2$ and $AgSnTe_2$.

4. The radio frequency switch according to any of the preceding claims, wherein the PCM further comprises a second alloy (A2) of at least two different chemical elements, wherein the second alloy contains at least one of Ge, Sn, Pb, Sb, Bi, S, Se, Te and Ag.

5. The radio frequency switch according to claim 4, wherein the second alloy (A2) is:

- an alloy of at least three different chemical elements selected from the group consisting of Sb, Bi, Se, Te and Ag, or
- an alloy of at least two different chemical elements selected from the group consisting of Ge, Sn, Pb, Sb, S, Se and Te.

6. The radio frequency switch according to claim 4 or 5, wherein the alloy (A2) has one of the following chemical formulae (II), (III) and (IV):

$$X^3X^4(X^5)_2 \qquad (II)$$

$$X^6X^7 \qquad (III)$$

$$X^6X^7{:}X^8_sX^9_t \qquad (IV)$$

wherein:

- $X^3$ and $X^4$ are each independently selected from Ag, Sb, Bi and a combination thereof,
- $X^5$ is selected from Se, Te and a combination of Se and Te,
- $X^6$ is selected from Ge, Sn, Pb and combinations thereof,
- $X^7$ is selected from S, Se, Te and combinations thereof,
- $X^8$ is selected from Pb, Sb and a combination of Pb and Sb,
- $X^9$ is selected from Se, Te and a combination of Se and Te, and
- s and t are each independently an integer between 1 and 3.

7. The radio frequency switch according to any of claims 4 to 6, wherein the alloy (A2) is selected from the group consisting of $AgSbSe_2$, $AgSbTe_2$, $AgBiSe_2$, $AgBiTe_2$, PbS, PbSe, PbTe, SnTe, GeTe, PbS:PbSe (1:1), PbSe:PbTe (1:1), $GeTe{:}Sb_2Te_3$ (1:1) and $GeTe{:}Sb_2Te_3$ (2:1).

8. The radio frequency switch according to any of claims 4 to 7, wherein the PCM comprises the alloy (A1) in an amount of 50 - 95 at.% and the alloy (A2) in an amount of 5 - 50 at.%.

9. The radio frequency switch according to any of claims 4 to 8, wherein the alloy (A1) and the alloy (A2) both have an octahedral-like atomic arrangement (preferably rock salt like structure) and the following condition is fulfilled:

$$|C1-C2|/C1 \leq 5\%$$

C1: lattice constant of alloy (A1) in Å
C2: lattice constant of alloy (A2) in Å.

10. The radio frequency switch according to any of the preceding claims, wherein

the PCM has a crystallization temperature above 150°C, and/or
the PCM has an annealing temperature below 400°C.

11. The radio frequency switch according to any of the preceding claims, wherein

the PCM in an on-state of the radio frequency switch has a resistivity below 3.4E-4 Ohm-cm, and/or
the PCM has a resistance ratio between an off state of the radio frequency switch and an on state of the radio frequency switch of at least 3E4.

12. The radio frequency switch according to any of claims 4 to 11, wherein the first alloy (A1) is a bad metal and the second alloy (A2) is a metavalent material.

13. The radio frequency switch of any one of claims 1 to 12, further comprising a heater thermally coupled to and electrically insulated from the phase change material.

14. A radio frequency device comprising:

the radio frequency switch of any one of claims 1 to 13, and
a radio frequency circuit coupled to at least one of the first radio frequency terminal and the second radio frequency terminal.

15. The radio frequency device of claim 14, wherein the radio frequency device is configured such that the radio frequency switch switches a signal having a frequency of at least 1 GHz when the radio frequency device is in operation.

# Fig. 1

# Fig. 2

Fig. 3

Fig. 4

Europäisches
Patentamt
European
Patent Office
Office européen
des brevets

# EUROPEAN SEARCH REPORT

**Application Number**

EP 24 20 9371

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/266517 A1 (WERNER DOUGLAS H [US] ET AL) 18 September 2014 (2014-09-18) <br> * paragraph [0036] * <br> * paragraph [0046] * <br> * figure 1 * <br> ----- | 1-3,10, 11,13-15 | INV. <br> H10N70/20 <br> H10N70/00 |
| X | US 2022/285614 A1 (LI JUNTAO [US] ET AL) 8 September 2022 (2022-09-08) <br> * paragraph [0056] - paragraph [0057] * <br> * paragraph [0062] * <br> * figures 1,2 * <br> ----- | 1-9,12, 14,15 | |

**TECHNICAL FIELDS SEARCHED (IPC)**

H10N

The present search report has been drawn up for all claims

| Place of search | Date of completion of the search | Examiner |
|---|---|---|
| Munich | 18 March 2025 | Gröger, Andreas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...............................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 20 9371

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2025

| Patent document cited in search report | Publication date | Patent family member(s) | Publication date |
|---|---|---|---|
| US 2014266517 A1 | 18-09-2014 | US 2014266517 A1<br>WO 2014159361 A1 | 18-09-2014<br>02-10-2014 |
| US 2022285614 A1 | 08-09-2022 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MOON et al.** 10.6 THz Figure-of-Merit Phase-change RF Switches with Embedded Micro-heater. *IEEE SiRF*, 2015
- **GUARNERI et al.** Metavalent Bonding in Crystalline Solids: How Does It Collapse?. *Adv. Mater.*, 2021, vol. 33, 2102356

- **WUTTIG et al.** Revisiting the Nature of Chemical Bonding in Chalcogenides to Explain and Design their Properties. *Adv. Mater.*, 2023, vol. 35, 2208485